# EUROPEAN PATENT SPECIFICATION

(11) **EP 3 246 954 B1**
(45) Date of publication and mention of the grant of the patent: **03.06.2020**
(21) Application number: 15877668.2
(22) Date of filing: 08.12.2015
(51) Int. Cl.: H01L 31/18, H01L 31/0216, H01L 21/228

(54) **MANUFACTURING METHOD OF AN N-TYPE BIFACIAL CELL**
HERSTELLUNGSVERFAHREN EINER BIFAZIALEN N-TYP-ZELLE
PROCÉDÉ DE FABRICATION D'UNE CELLULE BIFACIALE DE TYPE N

(30) Priority: 15.01.2015 CN 201510020649
(43) Date of publication of application: 22.11.2017
(73) Proprietor: Suzhou Talesun Solar Technologies Co., LTD., Jiangsu 215542 (CN)
(72) Inventor: WEI, Qingzhu, Suzhou City Jiangsu 215542 (CN); LU, Junyu, Suzhou City Jiangsu 215542 (CN); LIAN, Weifei, Suzhou City Jiangsu 215542 (CN); NI, Zhichun, Suzhou City Jiangsu 215542 (CN)
(74) Representative: Epping - Hermann - Fischer
(86) International application number: PCT/CN2015/096630
(87) International publication number: WO 2016/112757

(56) References cited:
- CN-A- 101 692 466
- CN-A- 103 151 427
- CN-A- 103 996 721
- CN-A- 104 009 118
- CN-A- 104 538 501
- CN-U- 201 699 033
- CN-U- 201 699 033

## Description

### TECHNICAL FIELD

The present disclosure relates to the technical field of solar energy, and in particular to a manufacturing method for an n-type bifacial cell.

### BACKGROUND

An n-type cell and a p-type cell all belong to a solar cell, the n-type cell has advantages of long lifetime, higher cell efficiency and no light-induced degradation compared with the p-type cell. For a bifacial euphotic n-type cell, the back of the cell can also absorb scattering light around to generate additional electric energy; so an n-type bifacial cell may generate much more electricity than a conventional p-type monofacial cell.

At present, in a process of an n-type bifacial cell, diffusion is performed by means of gas carrying boron tribromide steam. To make sure there is enough space for a boron source to diffuse onto a silicon wafer, the productivity may be limited. And in the foregoing diffusion manner, a non-diffused boron surface may be infected with a boron source inevitably and a PN junction is formed. So additional cleaning steps are required to remove the PN junction at a later stage, thereby influencing efficiency of production and process.

In addition, passivation and anti-reflection on a p-type surface (a diffused boron surface) are mainly realized by manufacturing silicon nitride or silicon oxide. However, in the manner based on silicon nitride, the passivation effect on the p-type surface is poor because the silicon nitride carries a positive charge; while in the manner based on silicon oxide, thermal silicon oxide is applied and the process is performed under a high temperature above 800°C, so the energy consumption is high and morphology of a formed PN junction is easy to be damaged, therefore it is difficult to control the process.

Therefore, it is necessary to propose solutions to solve the above problems.

### SUMMARY

In view of this, a manufacturing method for an n-type bifacial cell is provided according to the present disclosure to overcome disadvantages in the conventional art.

In order to attain the foregoing objective, the technical solution of a manufacturing method for an n-type bifacial cell provided in the present disclosure is described as follows.

A manufacturing method for an n-type bifacial cell includes:
a step S1 of performing treatment on an upper surface and a lower surface of an n-type silicon wafer by using an alkaline solution;
a step S2 of evenly coating a boron source on the upper surface of the n-type silicon wafer in a spin coating manner, and performing boron diffusion in a furnace tube; where in the step S2, the boron diffusion is performed in the furnace tube under atmosphere of mixed gases of oxygen and nitrogen, wherein a volume ratio of oxygen to nitrogen ranges from 1:5 to 1:20; and a condition for performing the boron diffusion in the furnace tube includes: a diffusion temperature ranging from 850°C to 1100°C, diffusion time ranging from 45min to 2h, and a diffusion sheet resistance ranging from 40Ω to 100Ω;
a step S3 of removing borosilicate glass, and manufacturing a mask on a surface of diffused boron;
a step S4 of performing phosphorus diffusion on the lower surface of the n-type silicon wafer, and forming a high-low-junction structure on the lower surface;
a step S5 of removing the mask manufactured in the step S3 and phosphorosilicate glass;
a step S6 of manufacturing a passivation anti-reflection film made of aluminum oxide and silicon nitride on the surface of the diffused boron, where the aluminum oxide is located under the silicon nitride in the passivation anti-reflection film, and manufacturing a silicon nitride passivation anti-reflection film on a surface of diffused phosphorus; and
a step S7 of manufacturing an electrode on the passivation anti-reflection film made of aluminum oxide and silicon nitride and on the silicon nitride passivation anti-reflection film to obtain the n-type bifacial cell.

As an improvement of the manufacturing method for an n-type bifacial cell in the present disclosure, in the step S1, a damaged layer is removed by using a NaOH solution, and texturing treatment is performed on the upper surface and the lower surface of the n-type silicon wafer.

As an improvement of the manufacturing method for an n-type bifacial cell in the present disclosure, in the step S3, the borosilicate glass is removed by cleaning using an HF solution, and the mask made of silicon oxide or silicon nitride is manufactured on the surface of the diffused boron by using a method of PECVD.

As an improvement of the manufacturing method for an n-type bifacial cell in the present disclosure, in the step S4, a condition for performing the phosphorus diffusion includes: a diffusion temperature ranging from 800°C to 900°C, diffusion time ranging from 30min to 2h, and a diffusion sheet resistance ranging from 20Ω to 60Ω.

As an improvement of the manufacturing method for an n-type bifacial cell in the present disclosure, in the step S6, the passivation anti-reflection film made of aluminum oxide and silicon nitride is manufactured by using a method of PECVD or ALD, and the silicon nitride passivation anti-reflection film is manufactured by using a method of PECVD.

As an improvement of the manufacturing method for an n-type bifacial cell in the present disclosure, in the step S7, an electrode in a shape of grid line is manufactured on the passivation anti-reflection film made of aluminum oxide and silicon nitride and on the silicon nitride passivation anti-reflection film in a screen printing manner, and sintering is performed.

In order to attain the foregoing objective, the technical solution of the n-type bifacial cell provided in the present disclosure is as follows.

An n-type bifacial cell includes: an n-type silicon wafer substrate, a p-type layer, a first passivation anti-reflection film, an N+ layer, a second passivation anti-reflection film, and grid line electrodes, where the p-type layer and the first passivation anti-reflection film are arranged in sequence on an upper surface of the n-type silicon wafer substrate, and the first passivation anti-reflection film includes aluminum oxide and silicon nitride stacked on the p-type layer in sequence;
the N+ layer and the second passivation anti-reflection film are arranged in sequence on a lower surface of the n-type silicon wafer substrate, and the second passivation anti-reflection film is a silicon nitride passivation anti-reflection film; and
the number of the grid line electrodes is greater than one, the grid line electrodes are arranged on the first passivation anti-reflection film and the second passivation anti-reflection film, and the grid line electrodes includes one or more primary grid line electrodes and one or more secondary grid line electrodes, and the primary grid line electrode on the first passivation anti-reflection film and the primary grid line electrode on the second passivation anti-reflection film are arranged symmetrically.

As an improvement of the n-type bifacial cell in the present disclosure, a thickness of the first passivation anti-reflection film ranges from 70nm to 90nm; a thickness of aluminum oxide in the first passivation anti-reflection film ranges from 5nm to 30nm; and a thickness of silicon nitride in the first passivation anti-reflection film ranges from 40nm to 85nm.

As an improvement of the n-type bifacial cell in the present disclosure, the number of the grid line electrodes is greater than one, the grid line electrodes are arranged on the first passivation anti-reflection film and the second passivation anti-reflection film, and the grid line electrodes includes one or more primary grid line electrodes and one or more secondary grid line electrodes, and the primary grid line electrode on the first passivation anti-reflection film and the primary grid line electrode on the second passivation anti-reflection film are arranged symmetrically.

Compared with the conventional art, the present disclosure has following advantageous effects. A manufacturing method for an n-type bifacial cell in the present disclosure is simple in process, and effectively improves the efficiency of the cell; the diffusion uniformity is guaranteed and the productivity of a furnace tube during diffusion is improved; and the coating scope of a boron source is effectively controlled, so a non-diffused area may not be infected with the boron source, and additional cleaning steps at a later stage may be saved.

In addition, a passivation layer manufacturing method for an n-type bifacial cell in the present disclosure is a low-temperature process, in which a PN junction is not damaged. And a method with a better passivation effect, in which aluminum oxide and silicon nitride are stacked for passivation, is applied. In the method, the aluminum oxide is for passivation, and the silicon nitride is for protecting and adjusting an optical parameter and for decreasing the reflectivity.

### BRIEF DESCRIPTION OF THE DRAWINGS

The accompany drawings used in the description of the embodiments or the conventional art will be described briefly as follows, so that the technical solutions according to the embodiments of the present disclosure or the conventional art will become more apparent. It is apparent that the accompany drawings in the following description show embodiments of the present disclosure. For those skilled in the art, other accompany drawings may be obtained according to these accompany drawings without any creative work.
Figure 1 is a schematic plan view illustrating an n-type silicon wafer in a manufacturing process of an n-type bifacial cell according to the present disclosure;
Figure 2 is a schematic plan view illustrating a case after a boron source is evenly coated on an upper surface of the n-type silicon wafer in a manufacturing process of an n-type bifacial cell according to the present disclosure;
Figure 3 is a schematic plan view illustrating a case after a p-type layer is formed on the upper surface of the n-type silicon wafer in a manufacturing process of an n-type bifacial cell according to the present disclosure;
Figure 4 is a schematic plan view illustrating a case after a mask is manufactured on the p-type layer in a manufacturing process of an n-type bifacial cell according to the present disclosure;
Figure 5 is a schematic plan view illustrating a case after a N+ layer is formed on a lower surface of the n-type silicon wafer in a manufacturing process of an n-type bifacial cell according to the present disclosure;
Figure 6 is a schematic plan view illustrating a case after the mask is removed in a manufacturing process of an n-type bifacial cell according to the present disclosure;
Figure 7 is a schematic plan view illustrating a case after a passivation anti-reflection film made of aluminum oxide and silicon nitride is manufactured on a surface of diffused boron in a manufacturing process of an n-type bifacial cell according to the present disclosure;
Figure 8 is a schematic view illustrating enlargement of a part structure in Figure 7.
Figure 9 is a schematic plan view illustrating a case after a silicon nitride passivation anti-reflection film is manufactured on a surface of diffused phosphorus in a manufacturing process of an n-type bifacial cell according to the present disclosure; and
Figure 10 is a schematic plan view illustrating a case after electrodes are manufactured in a manufacturing process of an n-type bifacial cell according to the present disclosure.

### DETAILED DESCRIPTION OF THE EMBODIMENTS

The technical solutions according to the embodiments of the present disclosure will be described in detail as follows. It is apparent that the described embodiments are only a part of the embodiments according to the present disclosure. All the other embodiments obtained by those skilled in the art based on the embodiments in the present disclosure without any creative work falls within the protection scope of the present disclosure.

A manufacturing method for an n-type bifacial cell in the present disclosure includes step S1 to step S7 in the following.

In step S1, treatment is performed on an upper surface and a lower surface of an n-type silicon wafer by using an alkaline solution.

In step S2, a boron source is evenly coated on the upper surface of the n-type silicon wafer in a spin coating manner or a screen printing manner, and boron diffusion is performed in a furnace tube.

In step S3, borosilicate glass is removed, and a mask is manufactured on a surface of diffused boron.

In step S4, phosphorus diffusion is performed on the lower surface of the n-type silicon wafer, and a high-low-junction structure is formed on the lower surface.

In step S5, the mask manufactured in the step S3 and phosphorosilicate glass are removed.

In step S6, a passivation anti-reflection film made of aluminum oxide and silicon nitride is manufactured on the surface of the diffused boron, and a silicon nitride passivation anti-reflection film is manufactured on a surface of diffused phosphorus.

In step S7, an electrode is manufactured on the passivation anti-reflection film made of aluminum oxide and silicon nitride and on the silicon nitride passivation anti-reflection film to obtain the n-type bifacial cell.

The above steps are described in detail as follows.

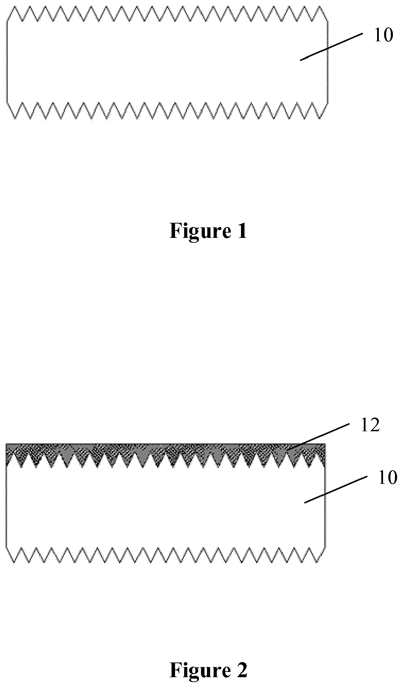

Referring to Figure 1, in step S1, treatment is performed on an upper surface and a lower surface of an n-type silicon wafer 10 by using an alkaline solution.

The step S1 aims to perform texturing treatment on the n-type silicon wafer 10 to improve the light trapping capability and the utilization of sunlight of the manufactured n-type bifacial cell. Specifically, in the above step S1, a damaged layer is removed by using a NaOH solution and texturing treatment is performed on the upper surface and the lower surface of the n-type silicon wafer. After the texturing treatment is performed, a textured surface, with a pyramid structure, is formed on the upper surface and the lower surface of the n-type silicon wafer.

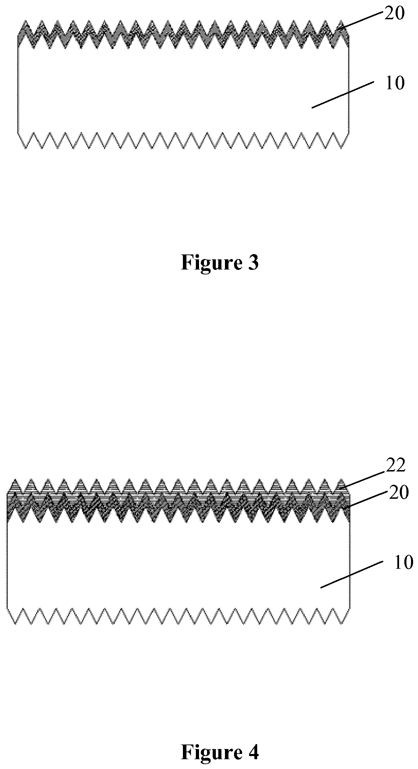

Referring to Figure 2 and Figure 3, in step S2, a boron source 12 is evenly coated on the upper surface of the n-type silicon wafer 10 in a spin coating manner or a screen printing manner, and boron diffusion is performed in a furnace tube, and a p-type layer 20 is formed on the upper surface of the n-type silicon wafer.

Because the spin coating manner or screen printing manner is used, it is guaranteed that the corresponding surface of each silicon wafer is evenly coated with the same amount of boron source, and the uniformity of diffusion is guaranteed. In this embodiment, if there are multiple silicon wafers, the boron diffusion is performed on the multiple silicon wafers in the furnace tube, there is no need to keep a lot of space among the multiple silicon wafers and a better productivity of the furnace tube is guaranteed.

Furthermore, the boron diffusion is performed in the furnace tube under atmosphere of mixed gases of oxygen and nitrogen, where a volume ratio of oxygen to nitrogen ranges from 1:5 to 1:20. A condition for performing the boron diffusion in the furnace tube includes: a diffusion temperature ranging from 850°C to 1100°C, diffusion time ranging from 45min to 2h, and a diffusion sheet resistance ranging from 40Ω to 100Ω.

Referring to Figure 4, in step S3, borosilicate glass is removed, and a mask 22 is manufactured on a surface of diffused boron 20.

The borosilicate glass is a by-product generated in the process of boron diffusion and may be removed by cleaning using an HF solution. And the mask made of silicon oxide or silicon nitride is manufactured on the surface of the diffused boron by using a method of PECVD, to protect the surface of the diffused boron, and to prevent the surface of the diffused boron from being influenced in the subsequent manufacturing steps.

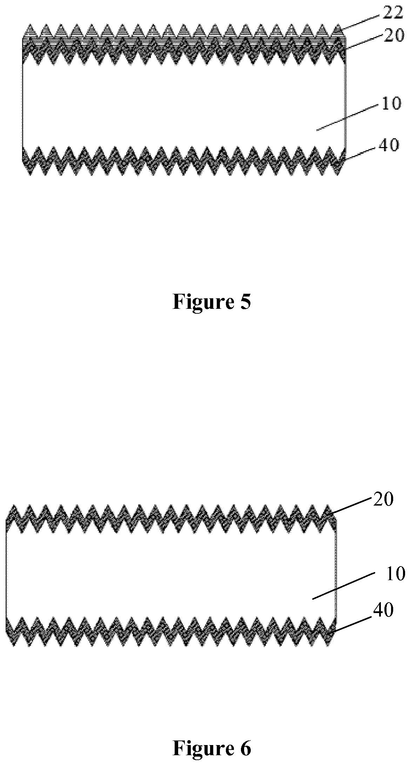

Referring to Figure 5, in step S4, phosphorus diffusion is performed on the lower surface of the n-type silicon wafer, and a high-low-junction structure 40 is formed on the lower surface.

The high-low-junction structure is an N+ layer of the n-type bifacial cell. Furthermore, liquid phosphorus oxychloride is used as a phosphorus source when performing the phosphorus diffusion. A condition for performing the phosphorus diffusion includes: a diffusion temperature ranging from 800°C to 900°C, diffusion time ranging from 30min to 2h, and a diffusion sheet resistance ranging from 20Ω to 60Ω.

Referring to Figure 6, in step S5, the mask 22 manufactured in the step S3 and phosphorosilicate glass are removed.

The phosphorosilicate glass is a by-product generated in the process of phosphorus diffusion and the borosilicate glass can be removed by cleaning using a HF solution. Furthermore, the mask manufactured in the above step S3 may also be removed by the HF solution when the phosphorosilicate glass is removed, and thus the manufactured p-type layer is exposed.

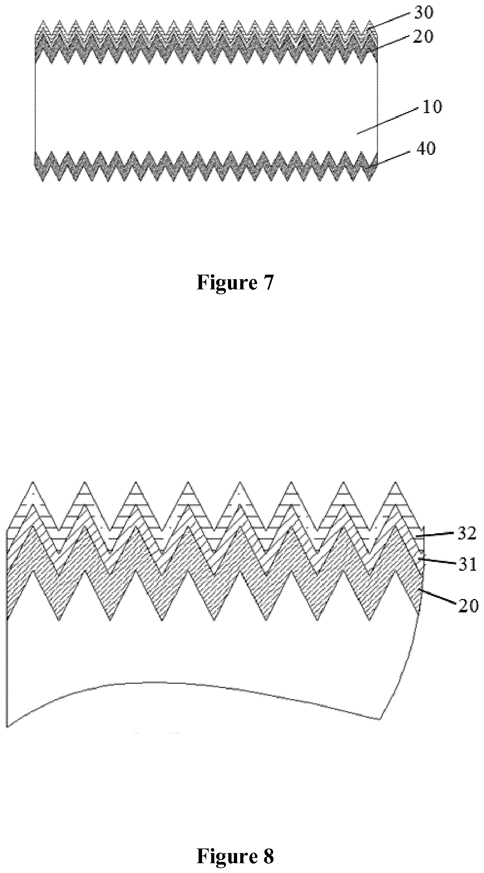

Referring to Figure 7 to Figure 9, in step S6, a passivation anti-reflection film 30 made of aluminum oxide 31 and silicon nitride 32 is manufactured on the surface of the diffused boron 20, and a silicon nitride passivation anti-reflection film 51 is manufactured on a surface of diffused phosphorus 40.

In this embodiment, aluminum oxide 31 and silicon nitride 32 are stacked for passivation, the aluminum oxide is for passivation, and the silicon nitride is for protecting and adjusting an optical parameter and for decreasing the reflectivity. Specifically, the passivation anti-reflection film 30 made of aluminum oxide and silicon nitride may be manufactured by using a method of PECVD or ALD, and the silicon nitride passivation anti-reflection film 50 may be manufactured by using a method of PECVD. Furthermore, the thickness of the passivation anti-reflection film 30 made from aluminum oxide and silicon nitride ranges from 70nm to 90nm, the thickness of aluminum oxide 31 ranges from 5nm to 30nm and the thickness of silicon nitride 32 ranges from 40nm to 85nm.

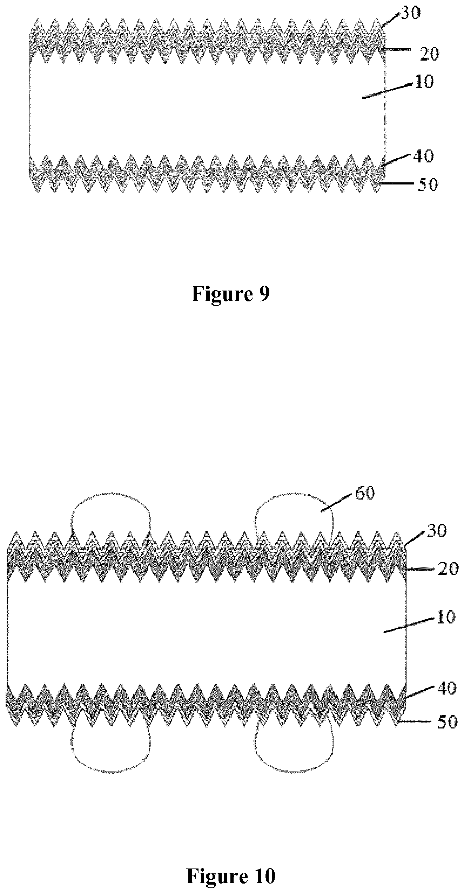

Referring to Figure 10, in step S7, an electrode 60 is manufactured on the passivation anti-reflection film 30 made of aluminum oxide and silicon nitride and on the silicon nitride passivation anti-reflection film 50 to obtain the n-type bifacial cell.

An electrode in a shape of grid line is manufactured on the passivation anti-reflection film made of aluminum oxide and silicon nitride and on the silicon nitride passivation anti-reflection film in a screen printing manner, and sintering is performed. Preferably, the electrode on the passivation anti-reflection film made of aluminum oxide and silicon nitride and the electrode on the silicon nitride passivation anti-reflection film are arranged symmetrically.

Furthermore, as shown in Figure 8 and Figure 10, an n-type bifacial cell manufactured according to the foregoing manufacturing method is also provided in the present disclosure based on the same technical concept. The n-type bifacial cell includes: an n-type silicon wafer substrate 10, a p-type layer 20, a first passivation anti-reflection film 30, an N+ layer 40, a second passivation anti-reflection film 50, and grid line electrodes 60.

Specifically, there are textured surfaces on the upper surface and the lower surface of the n-type silicon wafer substrate 10, and the textured surface has a pyramid structure.

The p-type layer 20 and the first passivation anti-reflection film 30 are arranged in sequence on an upper surface of the n-type silicon wafer substrate 10, and the first passivation anti-reflection film 30 includes aluminum oxide 31 and silicon nitride 32 stacked on the p-type layer 20 in sequence. The first passivation anti-reflection film 30 formed by stacking aluminum oxide 31 and silicon nitride 32 has a better passivation effect. In this embodiment, the thickness of the first passivation anti-reflection film 30 ranges from 70nm to 90nm; the thickness of aluminum oxide 31 in the first passivation anti-reflection film 30 ranges from 5nm to 30nm; and the thickness of silicon nitride 32 ranges from 40nm to 85nm.

The N+ layer 40 and the second passivation anti-reflection film 50 are arranged in sequence on a lower surface of the n-type silicon wafer substrate 10, that is, the back of the n-type silicon wafer substrate 10. The second passivation anti-reflection film 50 is a silicon nitride passivation anti-reflection film.

The number of the grid line electrodes 60 is greater than one. The grid line electrodes 60 are arranged on the first passivation anti-reflection film 30 and the second passivation anti-reflection film 50, to extract the formed current. The grid line electrodes 60 includes one or more primary grid line electrodes and one or more secondary grid line electrodes, and the grid line electrode 60 on the first passivation anti-reflection film 30 and the grid line electrode 60 on the second passivation anti-reflection film 50 are arranged symmetrically. The number of the primary grid line electrodes ranges from 2 to 5 and a width of the primary grid line electrode ranges from 0.5mm to 2.5mm. The number of the secondary grid line electrodes ranges from 50 to 150 and a width of the secondary grid line electrode ranges from 30um to 150um.

In summary, the manufacturing method for an n-type bifacial cell in the present disclosure is simple in process, and effectively improves the efficiency of the cell; the diffusion uniformity is guaranteed and the productivity of a furnace tube during diffusion is improved; and the coating scope of a boron source is effectively controlled, so a non-diffused area may not be infected with the boron source, and additional cleaning steps at a later stage may be saved.

In addition, a passivation layer manufacturing method for an n-type bifacial cell in the present disclosure is a low-temperature process, in which a PN junction is not damaged. And a method with a better passivation effect, in which aluminum oxide and silicon nitride are stacked for passivation, is applied. In the method, the aluminum oxide is for passivation, and the silicon nitride is for protecting and adjusting an optical parameter and for decreasing the reflectivity. The embodiments should be considered as an example rather than a limitation. The scope of the present disclosure is defined by the appended claims than by the foregoing description. In addition, it should be understood that, although this specification is described with embodiments, not every embodiment includes only one independent technical solution, and the description in the specification is merely for clarity. Those skilled in the art should consider the specification as a whole. The technical solutions in the embodiments may also be suitably combined to form other embodiments which can be understood by those skilled in the art.

## Claims

1. A manufacturing method for an n-type bifacial cell, comprising:
a step S1 of performing treatment on an upper surface and a lower surface of an n-type silicon wafer (10) by using an alkaline solution;
a step S2 of evenly coating a boron source (12) on the upper surface of the n-type silicon wafer (10) in a spin coating manner, and performing boron diffusion in a furnace tube; wherein in the step S2, the boron diffusion is performed in the furnace tube under atmosphere of mixed gases of oxygen and nitrogen, wherein a volume ratio of oxygen to nitrogen ranges from 1:5 to 1:20; and a condition for performing the boron diffusion in the furnace tube comprises: a diffusion temperature ranging from 850°C to 1100°C, diffusion time ranging from 45min to 2h, and a diffusion sheet resistance ranging from 40Ω to 100Ω;
a step S3 of removing by-product borosilicate glass generated in the step S2 of boron diffusion, and manufacturing a mask (12) on a surface of diffused boron (20);
a step S4 of performing phosphorus diffusion on the lower surface of the n-type silicon wafer, and forming a high-low-junction structure on the lower surface;
a step S5 of removing the mask manufactured in the step S3 and by-product phosphorosilicate glass generated in the step S4 of phosphorus diffusion;
a step S6 of manufacturing a passivation anti-reflection film (30) made of aluminum oxide (31) and silicon nitride (34) on the surface of the diffused boron (20), wherein the aluminum oxide (31) is located under the silicon nitride (34) in the passivation anti-reflection film (30), and manufacturing a silicon nitride passivation anti-reflection film (50) on a surface of diffused phosphorus (40); and
a step S7 of manufacturing an electrode (60) on the passivation anti-reflection film (30) made of aluminum oxide (31) and silicon nitride (34) and on the silicon nitride passivation anti-reflection film (50) to obtain the n-type bifacial cell.

2. The manufacturing method for an n-type bifacial cell according to claim 1, wherein in the step S1, a damaged layer is removed by using a NaOH solution, and texturing treatment is performed on the upper surface and the lower surface of the n-type silicon wafer.

3. The manufacturing method for an n-type bifacial cell according to claim 1, wherein in the step S3, the borosilicate glass is removed by cleaning using an HF solution, and the mask made of silicon oxide or silicon nitride is manufactured on the surface of the diffused boron by using a method of PECVD.

4. The manufacturing method for an n-type bifacial cell according to claim 1, wherein in the step S4, a condition for performing the phosphorus diffusion comprises: a diffusion temperature ranging from 800°C to 900°C, diffusion time ranging from 30min to 2h, and a diffusion sheet resistance ranging from 20Ω to 60Ω.

5. The manufacturing method for an n-type bifacial cell according to claim 1, wherein in the step S6, the passivation anti-reflection film made of aluminum oxide and silicon nitride is manufactured by using a method of PECVD or ALD, and the silicon nitride passivation anti-reflection film is manufactured by using a method of PECVD.

6. The manufacturing method for an n-type bifacial cell according to claim 1, wherein in the step S7, an electrode in a shape of grid line is manufactured on the passivation anti-reflection film made of aluminum oxide and silicon nitride and on the silicon nitride passivation anti-reflection film in a screen printing manner, and sintering is performed.

## Patentansprüche

1. Ein Herstellungsverfahren für eine bifaziale n-Typ-Zelle, umfassend:
einen Schritt S1 zum Durchführen einer Behandlung auf einer oberen Oberfläche und einer unteren Oberfläche einer n-Typ-Siliziumscheibe (10) unter Verwendung einer alkalischen Lösung;
einen Schritt S2 zum gleichmäßigen Auftragen einer Borquelle (12) auf die obere Oberfläche der n-Typ- Siliziumscheibe (10) in einer Rotationsbeschichtungsweise, und zum Durchführen einer Bordiffusion in einem Ofenrohr; wobei in dem Schritt S2 die Bordiffusion in dem Ofenrohr unter der Atmosphäre von Gasgemischen aus Sauerstoff und Stickstoff durchgeführt wird, wobei ein Volumenverhältnis von Sauerstoff zu Stickstoff in einem Bereich von 1:5 bis 1:20 liegt; und eine Bedingung für das Durchführen der Bordiffusion in dem Ofenrohr Folgendes umfasst: eine Diffusionstemperatur im Bereich von 850° C bis 1100° C, eine Diffusionszeit im Bereich von 45min bis 2h und einen Diffusionsschichtwiderstand im Bereich von 40Ω bis 100Ω;
einen Schritt S3 zum Entfernen des in Schritt S2 der Bordiffusion erzeugten Nebenproduktes Borsilikatglas und zum Herstellen einer Maske (12) auf einer Oberfläche aus diffundiertem Bor (20);
einen Schritt S4 zum Durchführen einer Phosphordiffusion auf der unteren Oberfläche der n-Typ-Siliziumscheibe, und zum Bilden einer Hoch-Tief-Übergangsstruktur auf der unteren Oberfläche;
einen Schritt S5 zum Entfernen der in Schritt S3 hergestellten Maske und des in Schritt S4 der Phosphordiffusion erzeugten Nebenprodukts Phosphorsilikatglas;
einen Schritt S6 zum Herstellen einer Passivierungs-Antireflexfolie (30) aus Aluminiumoxid (31) und Siliziumnitrid (34) auf der Oberfläche des diffundierten Bors (20), wobei sich das Aluminiumoxid (31) unter dem Siliziumnitrid (34) in der Passivierungs-Antireflexfolie (30) befindet, und zum Herstellen einer Siliziumnitrid-Passivierungs-Antireflexfolie (50) auf einer Oberfläche aus diffundiertem Phosphor (40); und
einen Schritt S7 zum Herstellen einer Elektrode (60) auf der Passivierungs-Antireflexfolie (30) aus Aluminiumoxid (31) und Siliziumnitrid (34) und auf der Siliziumnitrid-Passivierungs-Antireflexfolie (50), um die bifaziale n-Typ-Zelle zu erhalten.

2. Herstellungsverfahren für eine bifaziale n-Typ-Zelle gemäß Anspruch 1, wobei in dem Schritt S1 eine beschädigte Schicht unter Verwendung einer NaOH-Lösung entfernt wird und eine Texturierbehandlung auf der oberen Oberfläche und der unteren Oberfläche der n-Typ-Siliziumscheibe durchgeführt wird.

3. Herstellungsverfahren für eine bifaziale n-Typ-Zelle gemäß Anspruch 1, wobei in dem Schritt S3 das Borsilikatglas durch Reinigung unter Verwendung einer HF-Lösung entfernt wird und die Maske aus Siliziumoxid oder Siliziumnitrid auf der Oberfläche des diffundierten Bors unter Verwendung eines PECVD-Verfahrens hergestellt wird.

4. Herstellungsverfahren für eine bifaziale n-Typ-Zelle gemäß Anspruch 1, wobei in dem Schritt S4 eine Bedingung für das Durchführen der Phosphordiffusion Folgendes umfasst: eine Diffusionstemperatur im Bereich von 800° C bis 900° C, eine Diffusionszeit im Bereich von 30min bis 2h und einen Diffusionsschichtwiderstand im Bereich von 20Ω bis 60Ω.

5. Herstellungsverfahren für eine bifaziale n-Typ-Zelle gemäß Anspruch 1, wobei in dem Schritt S6 die Passivierungs-Antireflexfolie aus Aluminiumoxid und Siliziumnitrid unter Verwendung eines PECVD- oder ALD-Verfahrens hergestellt wird und die Siliziumnitrid-Passivierungs-Antireflexfolie unter Verwendung eines PECVD-Verfahrens hergestellt wird.

6. Herstellungsverfahren für eine bifaziale n-Typ-Zelle gemäß Anspruch 1, wobei in dem Schritt S7 eine Elektrode in Form einer Gitterlinie auf der Passivierungs-Antireflexfolie aus Aluminiumoxid und Siliziumnitrid und auf der Siliziumnitrid-Passivierungs-Antireflexfolie in einer Siebdruckweise hergestellt wird und Sintern durchgeführt wird.

## Revendications

1. Méthode de fabrication pour une cellule bifaciale de type n, comprenant :
une étape S1 d'exécution de traitement sur une surface supérieure et sur une surface inférieure d'une plaquette de silicium de type n (10) en utilisant une solution alcaline ;
une étape S2 de revêtement uniforme d'une source de bore (12) sur la surface supérieure de la plaquette de silicium de type n (10) selon un procédé d'enduction centrifuge, et d'exécution d'une diffusion de bore dans un conduit de four ; dans laquelle à l'étape S2, la diffusion de bore est exécutée dans le conduit de four dans une atmosphère de gaz mélangés d'oxygène et d'azote, dans laquelle un ratio volumique de l'oxygène par rapport à l'azote varie de 1:5 à 1:20 ; et une condition en vue de l'exécution de la diffusion de bore dans le conduit de four comprend : une température de diffusion variant de 850 °C à 1100 °C, un temps de diffusion variant de 45 min à 2 h, et une résistance d'écran de diffusion variant de 40 Ω à 100 Ω ;
une étape S3 de retrait du verre borosilicate dérivé généré à l'étape S2 de diffusion de bore, et de fabrication d'un masque (12) sur une surface de bore diffusé (20) ;
une étape S4 d'exécution de diffusion de phosphore sur la surface inférieure de la plaquette de silicium de type n, et de formation d'une structure de jonction haut-bas sur la surface inférieure ;
une étape S5 de retrait du masque fabriqué à l'étape S3 et du verre phosphorosilicate dérivé généré à l'étape S4 de diffusion de phosphore ;
une étape S6 de fabrication d'un film anti-reflet de passivation (30) fabriqué en oxyde d'aluminium (31) et en nitrure de silicium (34) sur la surface du bore diffusé (20),
dans laquelle l'oxyde d'aluminium (31) est situé au-dessous du nitrure de silicium (34) dans le film anti-reflet de passivation (30), et de fabrication d'un film anti-reflet de passivation de nitrure de silicium (50) sur une surface du phosphore diffusé (40) ; et
une étape S7 de fabrication d'une électrode (60) sur le film anti-reflet de passivation (30) fabriqué en oxyde d'aluminium (31) et en nitrure de silicium (34) et sur le film anti-reflet de passivation de nitrure de silicium (50) afin d'obtenir la cellule bifaciale de type n.

2. Méthode de fabrication pour une cellule bifaciale de type n selon la revendication 1, dans laquelle à l'étape S1, une couche endommagée est retirée en utilisant une solution de NaOH, et un traitement de texturation est exécuté sur la surface supérieure et sur la surface inférieure de la plaquette de silicium de type n.

3. Méthode de fabrication pour une cellule bifaciale de type n selon la revendication 1, dans laquelle à l'étape S3, le verre borosilicate est retiré en utilisant une solution HF, et le masque fabriqué en oxyde de silicium ou en nitrure de silicium est fabriqué sur la surface du bore diffusé en utilisant une méthode de PECVD

4. Méthode de fabrication pour une cellule bifaciale de type n selon la revendication 1, dans laquelle à l'étape S4, une condition en vue de l'exécution de la diffusion de phosphore comprend : une température de diffusion variant de 800 °C à 900 °C, un temps de diffusion variant de 30 min à 2 h, et une résistance d'écran de diffusion variant de 20 Ω à 60 Ω.

5. Méthode de fabrication pour une cellule bifaciale de type n selon la revendication 1, dans laquelle à l'étape S6, le film anti-reflet de passivation fabriqué en oxyde d'aluminium et en nitrure de silicium est fabriqué en utilisant une méthode de PECVD ou d'ALD, et le film anti-reflet de passivation de nitrure de silicium est fabriqué en utilisant une méthode de PECVD

6. Méthode de fabrication pour une cellule bifaciale de type n selon la revendication 1, dans laquelle à l'étape S7, une électrode en une forme de ligne de grille est fabriquée sur le film anti-reflet de passivation fabriqué en oxyde d'aluminium et en nitrure de silicium et sur le film anti-reflet de passivation de nitrure de silicium selon un procédé de sérigraphie, et un frittage est exécuté.
